(19) Europäisches Patentamt
European Patent Office
Office européen des brevets

(11) **EP 3 065 324 A1**

(12) **EUROPEAN PATENT APPLICATION**
published in accordance with Art. 153(4) EPC

(43) Date of publication:
**07.09.2016 Bulletin 2016/36**

(21) Application number: **14797749.0**

(22) Date of filing: **27.05.2014**

(51) Int Cl.:
*H04L 1/00* (2006.01)      *H04L 27/26* (2006.01)
*H04L 27/34* (2006.01)      *H03M 7/30* (2006.01)

(86) International application number:
**PCT/CN2014/078557**

(87) International publication number:
**WO 2014/183709 (20.11.2014 Gazette 2014/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.12.2013 CN 201310659571**

(71) Applicant: ZTE Corporation
**Shenzhen, Guangdong 518057 (CN)**

(72) Inventors:
• **WANG, Meiying**
  **Shenzhen**
  **Guangdong 518057 (CN)**

• **SUN, Hong**
  **Shenzhen**
  **Guangdong 518057 (CN)**
• **LI, Wei**
  **Shenzhen**
  **Guangdong 518057 (CN)**

(74) Representative: **Schröer, Gernot H. et al**
  **Meissner Bolte Patentanwälte**
  **Rechtsanwälte Partnerschaft mbB**
  **Bankgasse 3**
  **90402 Nürnberg (DE)**

(54) **METHOD AND DEVICE FOR PROCESSING SIGNAL SAMPLING-POINT DATA**

(57)    A method and a device for processing signal sampling point data (IQ data), the method includes: transforming time-domain signal sampling point data to be transmitted into frequency-domain signal sampling point data, encoding the frequency-domain signal sampling point data and then sending out. The technical solution uses the frequency-domain characteristics of IQ data in an LTE system, firstly transforms time-domain IQ data into frequency-domain IQ data, removes redundant information, then performs encoding and reduces the number of encoded points at a sending terminal to realize more effective compression of CPRI data in the LTE system, satisfy requirements on transmission bandwidth of current transmission access networks, and can realize quick and controlled high-efficiency compression and decompression functions of CPRI data in an LTE radio base station system.

```
┌─────────────────────┐
│ Transform time-domain IQ │
│ data to be transmitted into │  ⟶ S11
│ frequency-domain IQ data │
└─────────────────────┘
            │
            ▼
┌─────────────────────┐
│ Encode the frequency-domain IQ data, │  ⟶ S12
│ and then send out │
└─────────────────────┘
```

FIG. 2

**Description**

Technical Field

The present invention relates to the technical field of processing of signal sampling point data (called as IQ data for short, herein I-channel data refer to real part data of signal sampling point data, and Q-channel data refer to imaginary part data of signal sampling point data) of a CPRI (Common Public Radio Interface) in an LTE (Long Term Evolution) base station system, in particular to a method and device for processing IQ data of a CPRI in an LTE base station system.

Background of the Related Art

An LTE base station device is a distributed base station and consists of an eBBU (Evolved Building Base band Unit) and an eRRU (Evolved Radio Remote Unit), wherein the eBBU and the eRRU are connected through an optical fiber or a cable, and data interaction between the eBBU and the eRRU is performed by using common public radio interface protocol. A great amount of transmission bandwidth will be occupied to realize networking connections between the BBU and a plurality of RRUs in the LTE system. Currently, it is difficult to satisfy the transmission bandwidth of the transmission access network. Compressing IQ data of the CPRI is an access bandwidth reduction method which is very worthy of being studied.

The LTE system supports a radio network technology which uses OFDM (Orthogonal Frequency Division Multiplexing) technology and MIMO (Multiple Input Multiple Output) technology as a core. OFDM signals are signals superposed with random amplitudes and phases and usually have a higher PAPR (Peak to Average Power Ratio), most signal peaks are within a very small range and only a very few of signal peaks fluctuate greatly.

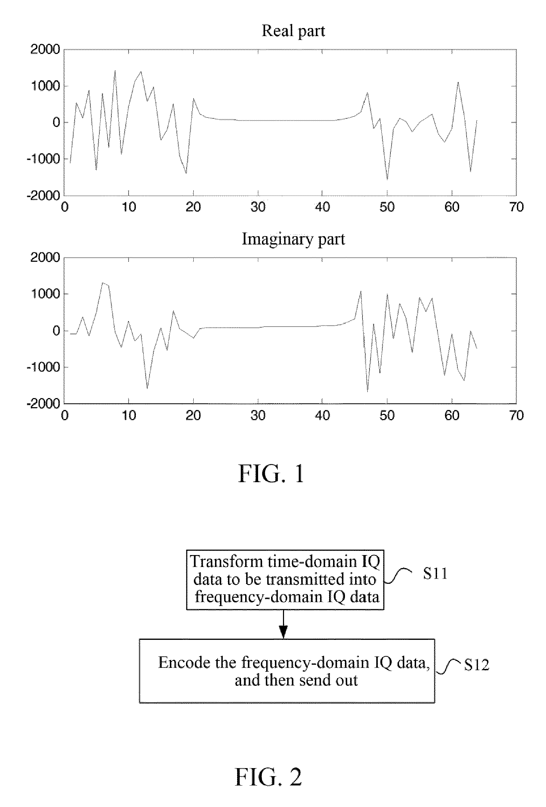

As shown in FIG. 1, Frequency-domain characteristics of IQ data of the CPRI interface in the LTE system have the similar characteristics, most signal peaks are within a very small range and only a very few of signal peaks fluctuate greatly. If common same bit number coding is adopted, the maximum value of signals decides bit number of coding, and high bits are 0 when other small-amplitude signals are encoded. As a result, the coding efficiency is extremely low and the transmission burden is increased.

The basic principle of a block floating point coding algorithm is to make corresponding scale adjustment to a data block and then perform scale recovery after calculation is completed. Block exponent adjustment is performed on a data block with a length of N and ineffective high-bit sign extension bits in a mantissa are removed, such that the data block shares the same exponent. Thereby, when addition and multiplication operations are performed on the data block, an additional exponent operation does not need to be performed, addition and multiplication operations are performed only on the mantissa, and it is as convenient as fixed-point operation. Since only one sign bit is reserved when block exponent adjustment is performed on the data block, a limited bit length can be fully utilized and the accuracy is improved. In addition, the introduction of the shared exponent further obtains a larger dynamic range than a fixed-point manner, and it is decided by the number of the high-bit sign extension bits of the data with the maximum absolute value in the data block.

Block floating point coding divides signal samples into groups (or called as blocks), then an exponent is solved for each group of samples and a mantissa is encoded, therefore forming a compressed block. Although encoding the mantissa and the exponent respectively increases the additional compression, it reduces the error caused by compression. With respect to exponent coding, a joint coding manner of two or more exponent differences can also be adopted, and a better compression effect can be realized by reducing the number of bits used for each exponent coding. According to a result of analyzing a great amount of statistical data, with respect to block floating point coding, 90% of differences of output exponent values corresponding to continuous two sample groups are within a range of {-1, 0, 1} and 98% are within a range of {-2, 1, 0, 1, 2}. Modification can be performed on exponent coding by using the information.

Block floating point coding can avoid the situation that all data are expressed by using fixed bit number, and block floating point coding is very suitable for the coding of IQ frequency-domain data in the LTE system. However, the related art has no solution of compression with respect to time-domain and frequency-domain joint characteristics of the CPRI data in the LTE radio base station system.

Summary of the Invention

The technical problem to be solved by the embodiments of the present invention is to provide a method and device for processing IQ data, so as to reduce transmission bandwidth and simultaneously reduce the costs of transmission devices.

In order to solve the above technical problem, the following technical solution is adopted:

A method for processing signal sampling point data includes:

transforming time-domain signal sampling point data to be transmitted into frequency-domain signal sampling point data, and

encoding the frequency-domain signal sampling point data to sent out.

Alternatively, before the step of transforming time-domain signal sampling point data to be transmitted into frequency-domain signal sampling point data, the method further includes:

buffering the time-domain signal sampling point data to be transmitted; and

when a number of sampling points of the buffered time-domain signal sampling point data to be transmitted reaches a threshold, processing the time-domain signal sampling point data according to the following way:

firstly putting real part data of time-domain signal sampling point data of a sampling point, then putting imaginary part data, and then putting real part data and imaginary part data of time-domain signal sampling point data of a next sampling point; or

firstly putting imaginary part data of time-domain signal sampling point data of a sampling point, then putting real part data, and then putting imaginary part data and real part data of time-domain signal sampling point data of a next sampling point.

Alternatively, the step of transforming time-domain signal sampling point data to be transmitted into frequency-domain signal sampling point data includes:

transforming the time-domain signal sampling point data into the frequency-domain signal sampling point data through Fast Fourier Transformation; and

extracting effective sampling points of the frequency-domain signal sampling point data according to respective symmetric characteristics of the real part data and the imaginary part data, and generating a frequency-domain signal sampling point data stream.

Alternatively, after transforming the time-domain signal sampling point data to be transmitted into the frequency-domain signal sampling point data, the method further includes:

performing amplitude compression on the frequency-domain signal sampling point data and generating an amplitude compression factor and compressed signal sampling point data.

Alternatively, the step of encoding the frequency-domain signal sampling point data includes:

encoding the frequency-domain signal sampling point data according to any one of the following coding ways:

block floating point coding, fuzzy block adaptive quantization coding, block adaptive vector quantization coding and block floating point quantization coding.

A device for processing signal sampling point data includes a transformation module and an encoding module, wherein:

the transformation module is configured to transform time-domain signal sampling point data to be transmitted into frequency-domain signal sampling point data; and

the encoding module is configured to encode the frequency-domain signal sampling point data to send out.

Alternatively, the device for processing signal sampling point data further includes a buffer module, wherein:

the buffer module is configured to buffer the time-domain signal sampling point data to be transmitted; and when a number of sampling points of the buffered time-domain signal sampling point data to be transmitted reaches a threshold, process the time-domain signal sampling point data according to the following way:

firstly putting real part data of time-domain signal sampling point data of a sampling point, then putting imaginary part data, and then putting real part data and imaginary part data of time-domain signal sampling point data of a next sampling point; or

firstly putting imaginary part data of time-domain signal sampling point data of a sampling point, then putting real part data, and then putting imaginary part data and real part data of time-domain signal sampling point data of a next sampling point.

Alternatively, the device for processing signal sampling point data further includes a generation module, wherein the transformation module is configured to transform the time-domain signal sampling point data to be transmitted into frequency-domain signal sampling point data according to the following way: transforming the time-domain signal sampling point data into the frequency-domain signal sampling point data through Fast Fourier Transformation; and the generation module is configured to extract effective sampling points of the frequency-domain signal sampling point data according to respective symmetric characteristics of the real part data and the imaginary part data, and generate a frequency-domain signal sampling point data stream.

Alternatively, the device for processing signal sampling point data further includes an amplitude compression module, wherein:

the amplitude compression module is configured to perform amplitude compression on the frequency-domain signal sampling point data and generate an amplitude compression factor and compressed signal sampling point data.

Alternatively, the encoding module is configured to encode the frequency-domain signal sampling point data according to the following way:

encoding the frequency-domain signal sampling point data according to any one of the following coding ways:

block floating point coding, fuzzy block adaptive quantization coding, block adaptive vector quantization coding and block floating point quantization coding.

A method for processing signal sampling point data includes:

decoding received frequency-domain signal sampling point data; and

transforming the decoded frequency-domain signal sampling point data into time-domain signal sampling point data.

Alternatively, after the step of decoding received frequency-domain signal sampling point data, the method further includes:

performing amplitude recovery on the decoded frequency-domain signal sampling point data according to an amplitude compression factor extracted from the received frequency-domain signal sampling point data; and

recovering the frequency-domain signal sampling point data whose amplitudes have been recovered to complete frequency-domain signal sampling point data according to respective symmetric characteristics of real part data and imaginary part data.

Alternatively, the step of transforming the decoded frequency-domain signal sampling point data into the time-domain signal sampling point data includes:

transforming the complete frequency-domain signal sampling point data into the time-domain signal sampling point data through inverse Fast Fourier Transformation.

A device for processing signal sampling point data includes a decoding module and an inverse transformation module, wherein:

the decoding module is configured to decode received frequency-domain signal sampling point data; and

the inverse transformation module is configured to transform the decoded frequency-domain signal sampling point data into time-domain signal sampling point data.

Alternatively, the device for processing signal sampling point data further includes a recovery module, wherein:

the recovery module is configured to perform amplitude recovery on the decoded frequency-domain signal sampling point data according to an amplitude compression factor extracted from the received frequency-domain signal sampling point data; and recover the frequency-domain signal sampling point data whose amplitudes have been recovered to complete frequency-domain signal sampling point data according to respective symmetric characteristics of real part data and imaginary part data.

Alternatively, the inverse transformation module is configured to transform the decoded frequency-domain signal sampling point data into time-domain signal sampling point data according to the following way:

transforming the complete frequency-domain signal sampling point data into the time-domain signal sampling point data through inverse Fast Fourier Transformation.

The method and the device for processing IQ data in the technical solution use the frequency-domain characteristics of IQ data in an LTE system, firstly transform time-domain IQ data into frequency-domain IQ data, remove redundant information, then perform encoding and reduce the number of encoded points at a sending terminal to realize more effective compression of CPRI data in the LTE system, satisfy requirements on transmission bandwidth of current transmission access networks, and can realize quick and controlled high-efficiency compression and decompression functions of CPRI data in an LTE radio base station system.

Brief Description of Drawings

The drawings described here are used for providing further understanding about the present invention and form a part of the present invention. The exemplary embodiments of the present invention and description thereof are used for explaining the present invention and do not constitute any improper limitation to the present invention. In the drawings:

FIG. 1 is a schematic diagram of frequency-domain characteristics of IQ data in an LTE system;

FIG. 2 is a flowchart of a method for processing IQ data at a sending terminal according to the embodiment of the present invention;

FIG. 3 is a flowchart of a method for processing IQ data at a receiving terminal according to the embodiment of the present invention;

FIG. 4 is a principle diagram of a system for processing IQ data according to the embodiment of the present invention;

FIG.5 is a schematic diagram of a device for processing IQ data at a sending terminal according to the embodiment of the present invention;

FIG.6 is a schematic diagram of a device for processing IQ data at a receiving terminal according to the embodiment of the present invention;

FIG. 7 is a schematic diagram of IQ interleaving according to the embodiment of the present invention.

Preferred Embodiments of the Invention

The embodiments of the present invention will be described below in detail in combination with the drawings. It needs to be stated that the embodiments and the features of the embodiments in the present application can be freely combined under the situation of no conflict.
FIG. 2 is a flowchart of a method for processing IQ data at a sending terminal according to the embodiment of the present invention. As shown in FIG. 2, the method includes the following steps:

In S11, time-domain IQ data to be transmitted are transformed into frequency-domain IQ data;

In S12, the frequency-domain IQ data are encoded and then sent out.

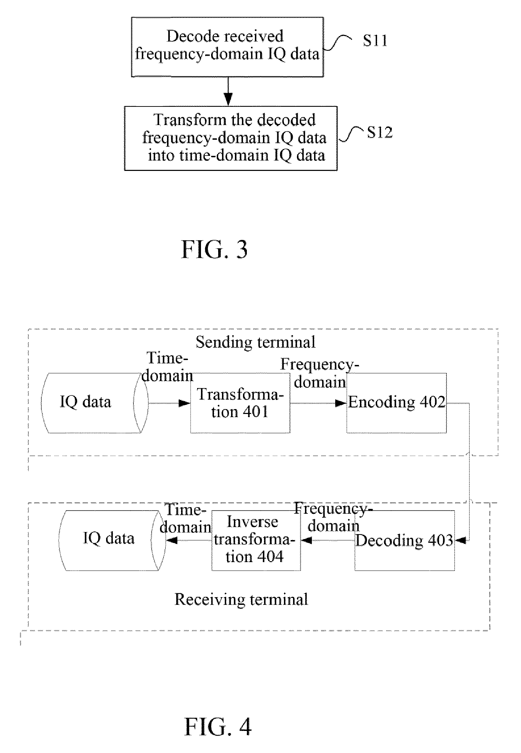

FIG. 3 is a flowchart of a method for processing IQ data at a receiving terminal according to the embodiment of the present invention. As shown in FIG. 3, the method includes the following steps:

In S21, received frequency-domain IQ data are decoded;

In S22, the decoded frequency-domain IQ data are transformed into time-domain IQ data.

FIG. 4 is a principle diagram of a system for processing IQ data according to the embodiment of the present invention. As shown in FIG. 4, in this embodiment, a sending terminal device may include:

a transformation module 401 is configured to transform time-domain IQ data to be transmitted into frequency-domain IQ data; and

an encoding module 402 is configured to encode the frequency-domain IQ data and then send out.

A receiving terminal device may include:

a decoding module 403 is configured to decode received frequency-domain IQ data; and

an inverse transformation module 404 is configured to transform the decoded frequency-domain IQ data into time-domain IQ data.

In the embodiment of the present invention, it is to primarily use the frequency-domain characteristics of the IQ data in the LTE system, and firstly transform the time-domain IQ data into frequency-domain IQ data, remove redundant information, and then perform encoding and reduce the number of encoded points at the sending terminal to realize more effective compression. Therefore, the decoded frequency-domain IQ data are transformed inversely into the time-domain IQ data correspondingly at the receiving terminal.

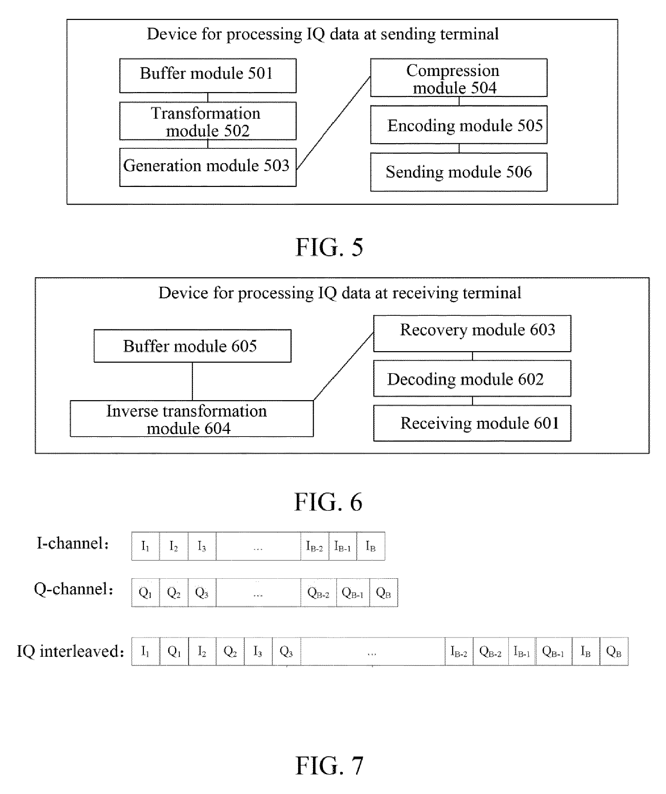

FIG. 5 is a schematic diagram of a device for processing IQ data at a sending terminal according to the embodiment of the present invention. As shown in FIG. 5, the device includes:

a buffer module 501 is configured to perform buffer processing on the time-domain IQ data to be transmitted;

in this embodiment, in consideration of reducing the number of DSP (Digital Signal Processing) chips, I (real part) channel and Q (imaginary part) channel data are not respectively compressed but are interleaved to obtain a buffer data block I_1 Q_1 I_2 Q_2...I_64 Q_64, i.e., the time-domain IQ sampling point data which need to be transmitted are stored, when the number of sampling points of the stored IQ data reaches a size of a buffer zone (or a threshold, supposed to be B), as shown in FIG. 7, according to the way that firstly I-channel (Q-channel) data of a sampling point are put, then Q-channel (I-channel) data are put, and then I-channel (Q-channel) and Q-channel (I-channel) data of a next sampling point are put, thus the data in the buffer zone are interleaved to obtain a column of interleaved data with a length of 2*B, and the interleaved data are sent to a transformation module;

A transformation module 502 is configured to transform the interleaved time-domain IQ data into frequency-domain IQ data;
in this embodiment, the transformation module can perform FFT (Fast Fourier Transformation) on the interleaved IQ time-domain data to obtain the frequency-domain IQ data.

A generation module 503 is configured to extract effective sampling points of the frequency-domain IQ data according to respective symmetric characteristics of the I-channel data and the Q-channel data, and generate a frequency-domain IQ data stream;
in this embodiment, the effective points are extracted from the frequency-domain I-channel and Q-channel data, and both the lengths of output I-channel and that of Q-channel data are B+1.

Since $(I_2... I_B)$ and $(I_B+2, ..., I_{2*B})$ except $I_1$ and $I_B+1$ in I-channel data are in axis symmetry about $I_{B+1}$, and $(Q_2,..., Q_B)$ and $(Q_B+2, ..., Q_{2*B})$ except $Q_1$ and $Q_{B+1}$ in Q-channel data are in point symmetry about $Q_{B+1}$ (i.e., $Q_2=-Q_{2*B},..., Q_B=-Q_{B+2}$), only the first and (B+1)th points need to be taken, the number of effective points of I-channel is $(I_1, ..., I_B+1)$ or $(I_1, I_{B+1}..., I_{2*B})$, and the number of effective points of Q-channel is $(Q_1, ..., Q_{B+1})$ or $(Q_1, Q_{B+1}..., Q_{2*B})$, herein $Q_1$ is considered to be a constant which is constantly 0.

An amplitude compression module or a compression module 504 is configured to perform amplitude compression on the frequency-domain IQ data and generate an amplitude compression factor F and compressed IQ data.

An encoding module 505 is configured to encode the compressed IQ data;

in this embodiment, block floating point coding can be respectively performed on the I-channel and Q-channel data, except the first data, whose amplitudes have been compressed, and encoded data and first input data are outputted;

A sending module 506 is configured to send the amplitude compression factor F and the encoded IQ data.

FIG. 6 is a schematic diagram of a device for processing IQ data at a receiving terminal according to the embodiment of the present invention. As shown in FIG. 6, the device includes:

a receiving module 601, configured to receive data and extract an amplitude compression factor F and encoded IQ data;

a decoding module 602, configured to decode the IQ data;

a recovery module 603, configured to perform amplitude recovery on the decoded IQ data according to the amplitude compression factor F to obtain corresponding frequency-domain IQ data outputted by the generation module in FIG. 3, and perform recovery according to respective symmetry of I-channel and Q-channel data to obtain corresponding complete IQ frequency-domain data outputted by the transformation module in FIG. 3;

an inverse transformation module 604, configured to process the frequency-domain IQ data to obtain time-domain IQ data;

in this embodiment, IFFT can be performed on the complete frequency-domain IQ data to obtain the time-domain IQ interleaved data, and then the time-domain IQ sampling point data are recovered according to an IQ interleaving way as shown in FIG. 7;

a buffer module 605, configured to buffer the data for subsequent signal processing after processing the time-domain IQ data into I-channel and Q-channel data.

The embodiment of the present invention further provides a system for processing IQ data. The system includes the device for processing IQ data at the sending terminal and the device for processing IQ data at the receiving terminal.

Description is made below through a specific embodiment.

In this embodiment, IQ data are stored with 16 bits, B=64, IQ interleaving is performed according to the way as shown in FIG. 7, and I-channel and Q-channel data of IQ data obtained after FFT have respective symmetric characteristics. Since information at 63 points (66:128) of real parts and imaginary parts is redundant information and does not need to participate in encoding, the original time-domain signals may be completely recovered through IFFT at the decoding terminal by using first 65 data. With respect to amplitude compression, by selecting different compression factors such as 1, 2, 4 and 256, different frequency-domain amplitude compression may be obtained.

For example, if 64 samples are used as a basic processing data block, in consideration of reducing the number of DSP (Digital Signal Processing) chips, I-channel and Q-channel data are not respectively compressed but are interleaved to obtain a buffer data block I_1 Q_1 I_2 Q_2...I_64 Q_64. FFT is performed on the obtained 128 point real signals, and after transformation, block floating point coding only needs to be performed respectively on real parts and imaginary parts of the first point to the 65th point.

Block floating point coding is performed respectively on I-channel effective signals and Q-channel effective signals obtained after FFT. With respect to the I-channel and Q-channel, since B=64 in this embodiment, the size of a buffer zone of the I-channel and Q-channel excluding the first data is 64, and 64 sample values are read at one time to perform block floating point coding. In this embodiment, 64-dimension data are divided into 16 data blocks, each having 4 data. Then, the maximum values Block_max of the 16 data blocks are respectively determined. Then, an exponent of each block is determined through formulas (1) and (2) as follows:

$$2^{n\_exp-1} < Block\_max \qquad (1)$$

$$2^{n\_exp} > Block\_max \qquad (2)$$

Block exponents n_exp of the 16 groups of data are obtained through calculation. Since positive and negative data are considered, a sign bit needs to be added and finally block exponents n_exp=n_exp+1 are obtained. Finally, coding is performed respectively on the input 16 groups of samples according to the obtained block exponents n_exp, the number of bits needed by each group of samples is the corresponding block exponent n_exp and the corresponding block mantissa is obtained.

After the encoded signals reach the receiving terminal, decoding, amplitude increase and inverse FFT are performed to obtain the time-domain signals. Amplitude increase is the "inverse" of the amplitude compression, inverse FFT is the "inverse" of FFT, which are not introduced here. Decoding is the "inverse" of encoding, data obtained after decoding are points from the first point to the 65th point, and for real parts, the points from the second point to the 64th point only need to be turned over with respect to the 65th point to obtain points from the 66th point to the 128th point, i.e., the 66th point is equal to the 64th point, the 67th point is equal to the 63th point, and the 68th point is equal to the 62th point; and for imaginary parts, the points from the second point to the 64th point only need to be turned over with respect to the 65th point and the sign is reversed to obtain the points from the 66th point to the 128th point, i.e., the 66th point and the 64th point are equal in size and opposite in sign, the 67th point and the 63th point are equal in size and opposite in sign, and the 68th point and the 62th point are equal in size and opposite in sign.

When the amplitude compression factor is 1, compression situations of I and Q interleaving are as shown in Table 1.

Table 1 Compression situations of I and Q interleaving

| Original data | Coding length | Average code length |
|---|---|---|
| Real part (2:65) | 644 | 10.0625 |
| Imaginary part (2:65) | 660 | 10.3125 |
| Overall | 644+660+16 | 10.3125 |

As shown by experiment results, I and Q interleaved data blocks can still be very well compressed to about 10bit in a nearly lossless compression manner, and an EVM (Error Vector Magnitude) caused thereby is 0.044207%.

EVM values measured by experiments at different amplitude compression factors F are as shown in Table 2.

Table 2 Relationship between F and EVM values

| Compression factor | 1 | 2 | 4 | 8 | 16 | 32 | 64 | 128 | 256 |
|---|---|---|---|---|---|---|---|---|---|
| IQ data (time-domain ) average bit number | 16 | 16 | 16 | 16 | 16 | 16 | 16 | 16 | 16 |
| Average bit number after encoding | 10.3125 | 9.3438 | 8.4375 | 7.5625 | 6.5625 | 5.8438 | 5.0313 | 4.4375 | 3.7813 |
| Compression rate (%) | 64.4531 | 58.3988 | 52.7344 | 47.2656 | 41.0156 | 36.5238 | 31.4456 | 27.7344 | 23.6331 |
| EVM value (%) | 0.044207 | 0.082037 | 0.17921 | 0.32747 | 0.73936 | 1.3016 | 2.4617 | 4.7238 | 7.802 |

The embodiments of the present invention combine FFT with block floating point coding, in combination with frequency-domain characteristics of data, it is to remove redundant information, reduce the number of encoded points and realize more effective compression. Compared with the existing compression technique, the compression effect of the embodiments of the present invention is more remarkable, and with the development of hardware, the space for improvement is greater.

The embodiments of the present invention can further adopt other coding solutions according to the frequency-domain statistical characteristics of the IQ data in the LTE system, such as FBAQ (Fuzzy Block Adaptive Quantization) coding, BAVQ (Block Adaptive Vector Quantization) coding and BFPQ (Block Floating Point Quantization) coding and the like, and it is expected to further improve the compression performance.

One ordinary skilled in the art can understand that all or partial steps in the above-mentioned methods can be completed by relevant hardware instructed by a program, and the program can be stored in a computer readable storage medium such as a read only memory, a magnetic disk or a compact disk etc. Alternatively, all or partial steps of the above-mentioned embodiments can also be implemented by using one or more integrated circuits. Correspondingly, each module/unit in the above-mentioned embodiments can be implemented by means of hardware, and can also be implemented by means of a software function module. The present invention is not limited to combinations of hardware and software in any specific form.

The embodiments are just preferred embodiments of the present invention. Of course, the present invention may also have other embodiments. One skilled in the art can make various corresponding modifications and variations according to the present invention without departing from the rule and essence of the present invention. However, all these corresponding modifications and variations shall also belong to the protection range of claims annexed to the present invention.

Industrial Applicability

The method and the device for processing IQ data in the technical solution use the frequency-domain characteristics of IQ data in an LTE system, firstly transform time-domain IQ data into frequency-domain IQ data, remove redundant information, then perform encoding and reduce the number of encoded points and at a sending terminal to realize more effective compression of CPRI data in the LTE system to satisfy requirements on transmission bandwidth of current transmission access networks, and realize quick and controlled high-efficiency compression and decompression functions of CPRI data in an LTE radio base station system. Therefore, the present invention has very strong industrial applicability.

**Claims**

1. A method for processing signal sampling point data, comprising:

   transforming time-domain signal sampling point data to be transmitted into frequency-domain signal sampling point data,
   encoding the frequency-domain signal sampling point data to send out.

2. The method for processing signal sampling point data according to claim 1, wherein, before the step of transforming time-domain signal sampling point data to be transmitted into frequency-domain signal sampling point data, the method further comprises:

   buffering the time-domain signal sampling point data to be transmitted; and
   when a number of sampling points of the buffered time-domain signal sampling point data to be transmitted reaches a threshold, processing the time-domain signal sampling point data according to the following way:

   firstly putting real part data of time-domain signal sampling point data of a sampling point, then putting imaginary part data, and then putting real part data and imaginary part data of time-domain signal sampling point data of a next sampling point; or
   firstly putting imaginary part data of time-domain signal sampling point data of a sampling point, then putting real part data, and then putting imaginary part data and real part data of time-domain signal sampling point data of a next sampling point.

3. The method for processing signal sampling point data according to claim 1, wherein the step of transforming time-domain signal sampling point data to be transmitted into frequency-domain signal sampling point data comprises:

   transforming the time-domain signal sampling point data into the frequency-domain signal sampling point data through Fast Fourier Transformation; and
   extracting effective sampling points of the frequency-domain signal sampling point data according to respective symmetric characteristics of the real part data and the imaginary part data, and generating a frequency-domain signal sampling point data stream.

4. The method for processing signal sampling point data according to claim 1, wherein, after transforming the time-domain signal sampling point data to be transmitted into the frequency-domain signal sampling point data, the method further comprises:

   performing amplitude compression on the frequency-domain signal sampling point data and generating an amplitude compression factor and compressed signal sampling point data.

5. The method for processing signal sampling point data according to any one of claims 1-4, wherein the step of encoding the frequency-domain signal sampling point data comprises:

encoding the frequency-domain signal sampling point data according to any one of the following coding ways:

block floating point coding, fuzzy block adaptive quantization coding, block adaptive vector quantization coding and block floating point quantization coding.

6. A device for processing signal sampling point data, comprising a transformation module and an encoding module, wherein:

the transformation module is configured to transform time-domain signal sampling point data to be transmitted into frequency-domain signal sampling point data; and
the encoding module is configured to encode the frequency-domain signal sampling point data to send out.

7. The device for processing signal sampling point data according to claim 6, further comprising a buffer module, wherein:

the buffer module is configured to buffer the time-domain signal sampling point data to be transmitted; and when a number of sampling points of the buffered time-domain signal sampling point data to be transmitted reaches a threshold, process the time-domain signal sampling point data according to the following way:

firstly putting real part data of time-domain signal sampling point data of a sampling point, then putting imaginary part data, and then putting real part data and imaginary part data of time-domain signal sampling point data of a next sampling point; or
firstly putting imaginary part data of time-domain signal sampling point data of a sampling point, then putting real part data, and then putting imaginary part data and real part data of time-domain signal sampling point data of a next sampling point.

8. The device for processing signal sampling point data according to claim 6, further comprising a generation module, wherein
the transformation module is configured to transform time-domain signal sampling point data to be transmitted into frequency-domain signal sampling point data according to the following way: transforming the time-domain signal sampling point data into the frequency-domain signal sampling point data through Fast Fourier Transformation; and
the generation module is configured to extract effective sampling points of the frequency-domain signal sampling point data according to respective symmetric characteristics of the real part data and the imaginary part data, and generate a frequency-domain signal sampling point data stream.

9. The device for processing signal sampling point data according to claim 6, further comprising an amplitude compression module, wherein:

the amplitude compression module is configured to perform amplitude compression on the frequency-domain signal sampling point data and generate an amplitude compression factor and compressed signal sampling point data.

10. The device for processing signal sampling point data according to any one of claims 6-9, wherein the encoding module is configured to encode the frequency-domain signal sampling point data according to the following way:

encoding the frequency-domain signal sampling point data according to any one of the following coding ways:

block floating point coding, fuzzy block adaptive quantization coding, block adaptive vector quantization coding and block floating point quantization coding.

11. A method for processing signal sampling point data, comprising:

decoding received frequency-domain signal sampling point data; and
transforming the decoded frequency-domain signal sampling point data into time-domain signal sampling point data.

**12.** The method for processing signal sampling point data according to claim 11, wherein, after the step of decoding received frequency-domain signal sampling point data, the method further comprises:

performing amplitude recovery on the decoded frequency-domain signal sampling point data according to an amplitude compression factor extracted from the received frequency-domain signal sampling point data; and recovering the frequency-domain signal sampling point data whose amplitudes have been recovered to complete frequency-domain signal sampling point data according to respective symmetric characteristics of real part data and imaginary part data.

**13.** The method for processing signal sampling point data according to claim 12, wherein the step of transforming the decoded frequency-domain signal sampling point data into time-domain signal sampling point data comprises:

transforming the complete frequency-domain signal sampling point data into the time-domain signal sampling point data through inverse Fast Fourier Transformation.

**14.** A device for processing signal sampling point data, comprising a decoding module and an inverse transformation module, wherein:

the decoding module is configured to decode received frequency-domain signal sampling point data; and the inverse transformation module is configured to transform the decoded frequency-domain signal sampling point data into time-domain signal sampling point data.

**15.** The device for processing signal sampling point data according to claim 14, further comprising a recovery module, wherein:

the recovery module is configured to perform amplitude recovery on the decoded frequency-domain signal sampling point data according to an amplitude compression factor extracted from the received frequency-domain signal sampling point data; and recover the frequency-domain signal sampling point data whose amplitudes have been recovered to complete frequency-domain signal sampling point data according to respective symmetric characteristics of real part data and imaginary part data.

**16.** The device for processing signal sampling point data according to claim 15, wherein the inverse transformation module is configured to transform the complete frequency-domain signal sampling point data into the time-domain signal sampling point data through inverse Fast Fourier Transformation.

Real part

Imaginary part

FIG. 1

Transform time-domain IQ
data to be transmitted into
frequency-domain IQ data — S11

Encode the frequency-domain IQ data,
and then send out — S12

FIG. 2

```
┌─────────────────────────┐
│    Decode received      │ ⌒ S11
│ frequency-domain IQ data│
└─────────────────────────┘
             │
             ▼
┌─────────────────────────┐
│   Transform the decoded │ ⌒ S12
│ frequency-domain IQ data│
│  into time-domain IQ data│
└─────────────────────────┘
```

# FIG. 3

```
┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐
              Sending terminal
│           Time-            Frequency-                            │
            domain            domain
│  ╭──────────╮    ┌──────────┐    ┌──────────────┐               │
   │ IQ data  │──▶ │Transforma│──▶ │ Encoding 402 │
│  ╰──────────╯    │ tion 401 │    └──────────────┘               │
                   └──────────┘              │
└ ─ ─ ─ ─ ─ ─ ─ ─ ─ ─ ─ ─ ─ ─ ─ ─ ─ ─ ─ ─ ─ ─│─ ─ ─ ─ ─ ─ ─ ─ ─ ┘
                                              │
┌ ─ ─ ─ ─ ─ ─ ─ ─ ─ ─ ─ ─ ─ ─ ─ ─ ─ ─ ─ ─ ─ ─│─ ─ ─ ─ ─ ─ ─ ─ ─ ┐
           Time-           Frequency-
│  ╭──────────╮ domain ┌──────────┐ domain ┌──────────────┐      │
   │ IQ data  │◀───────│ Inverse  │◀───────│ Decoding 403 │◀─────
│  ╰──────────╯        │transforma│        └──────────────┘      │
                       │ tion 404 │
│                      └──────────┘                              │
              Receiving terminal
└ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘
```

# FIG. 4

```
┌──────────────────────────────────────────────────────────────────┐
│          Device for processing IQ data at sending terminal          │
│                                                                      │
│   ┌─────────────────────────┐         ┌──────────────────────────┐ │
│   │   Buffer module 501      │         │      Compression          │ │
│   └─────────────────────────┘         │     module 504            │ │
│             │                          └──────────────────────────┘ │
│   ┌─────────────────────────┐         ┌──────────────────────────┐ │
│   │   Transformation         │         │  Encoding module 505      │ │
│   │   module 502             │         └──────────────────────────┘ │
│   └─────────────────────────┘                                       │
│             │                          ┌──────────────────────────┐ │
│   ┌─────────────────────────┐         │  Sending module 506       │ │
│   │ Generation module 503    │         └──────────────────────────┘ │
│   └─────────────────────────┘                                       │
└──────────────────────────────────────────────────────────────────┘
```

## FIG. 5

```
┌──────────────────────────────────────────────────────────────────┐
│          Device for processing IQ data at receiving terminal        │
│                                         ┌──────────────────────────┐│
│                                         │  Recovery module 603      ││
│   ┌─────────────────────────┐           └──────────────────────────┘│
│   │   Buffer module 605      │           ┌──────────────────────────┐│
│   └─────────────────────────┘           │  Decoding module 602      ││
│             │                            └──────────────────────────┘│
│   ┌─────────────────────────┐           ┌──────────────────────────┐│
│   │  Inverse transformation  │           │  Receiving module 601     ││
│   │  module 604              │           └──────────────────────────┘│
│   └─────────────────────────┘                                        │
└──────────────────────────────────────────────────────────────────┘
```

## FIG. 6

I-channel: | $I_1$ | $I_2$ | $I_3$ | ... | $I_{B-2}$ | $I_{B-1}$ | $I_B$ |

Q-channel: | $Q_1$ | $Q_2$ | $Q_3$ | ... | $Q_{B-2}$ | $Q_{B-1}$ | $Q_B$ |

IQ interleaved: | $I_1$ | $Q_1$ | $I_2$ | $Q_2$ | $I_3$ | $Q_3$ | ... | $I_{B-2}$ | $Q_{B-2}$ | $I_{B-1}$ | $Q_{B-1}$ | $I_B$ | $Q_B$ |

## FIG. 7

# INTERNATIONAL SEARCH REPORT

International application No.

PCT/CN2014/078557

## A. CLASSIFICATION OF SUBJECT MATTER

H04L 1/00 (2006.01) i

According to International Patent Classification (IPC) or to both national classification and IPC

## B. FIELDS SEARCHED

Minimum documentation searched (classification system followed by classification symbols)

H04L; H04Q

Documentation searched other than minimum documentation to the extent that such documents are included in the fields searched

Electronic data base consulted during the international search (name of data base and, where practicable, search terms used)

CNPAT, CNKI, WPI, EPODOC, GOOGLE: common public radio interface, time domain, frequency domain, fourier, sample, point, CPRI, time, domain, frequency, code, coding, real part, imaginary part

## C. DOCUMENTS CONSIDERED TO BE RELEVANT

| Category* | Citation of document, with indication, where appropriate, of the relevant passages | Relevant to claim No. |
|---|---|---|
| X | CN 103139129 A (ALCATEL-LUCENT SHANGHAI BELL CO., LTD. et al.), 05 June 2013 (05.06.2013), description, paragraphs [0051]-[0106], and figures 3, 4a-4f, 11a, 11b and 12a-12f | 1-16 |
| A | CN 102801681 A (DATANG MOBILE COMMUNICATIONS EQUIPMENT CO., LTD.), 28 November 2012 (28.11.2012), the whole document | 1-16 |
| A | CN 103312413 A (POTEVIO INSTITUTE OF TECHNOLOGY CO., LTD.), 18 September 2013 (18.09.2013), the whole document | 1-16 |

☐ Further documents are listed in the continuation of Box C.  ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 04 August 2014 (04.08.2014) | **02 September 2014 (02.09.2014)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **YANG, Dan** Telephone No.: (86-10) **82245238** |

Form PCT/ISA/210 (second sheet) (July 2009)

## INTERNATIONAL SEARCH REPORT
### Information on patent family members

| International application No. |
| --- |
| **PCT/CN2014/078557** |

| Patent Documents referred in the Report | Publication Date | Patent Family | Publication Date |
| --- | --- | --- | --- |
| CN 103139129 A | 05 June 2013 | WO 2013084058 A1 | 13 June 2013 |
| CN 102801681 A | 28 November 2012 | None | |
| CN 103312413 A | 18 September 2013 | None | |

Form PCT/ISA/210 (patent family annex) (July 2009)